# DEMANDE DE BREVET EUROPEEN

(11) **EP 3 647 261 A1**
(43) Date de publication de la demande: **06.05.2020**
(21) Numéro de dépôt: 19206426.9
(22) Date de dépôt: 31.10.2019
(51) Int. Cl.: B81B 3/00, G02B 26/08, H02K 33/18, H02K 41/03

(54) **DISPOSITIF MICROMECANIQUE A ACTIONNEMENT ELECTROMAGNETIQUE LOCAL**

(30) Priorité: 31.10.2018 CH 13262018
(71) Demandeur: Sercalo Microtechnology Ltd., 9494 Schaan (LI)
(72) Inventeur: Kuenlin, Vincent, 2000 Neuchatel (CH); Marxer, Cornel, 2000 Neuchatel (CH)
(74) Mandataire: Riederer Hasler & Partner Patentanwälte AG

(57) **Abrégé**

L'invention concerne un dispositif micromécanique (1, 2) à actionnement électromagnétique comprenant une base (20) et un MEMS (18). Le MEMS comprend un élément rotatif (10) mobile selon un ou 2 axes de rotation. La base comprend des stators (22) forment chacun un premier pôle intérieur (23), un pôle extérieur (24) et un entrefer (25).
Pour augmenter la fiabilité et la stabilité mécanique du dispositif, lesdits premiers pôles intérieurs (23) sont montés solidaires l'un de l'autre sur ladite base (20).

## Description

La présente invention est relative aux microsystèmes électromécaniques, plus connus sous l'appellation MEMS de l'anglais Micro Electro Mechanical Systems. Elle concerne plus précisément un dispositif micromécanique comportant un élément rotatif mobile selon au moins un axe de rotation, et des moyens d'actionnement de cet élément rotatif de type électromagnétique.

De tels dispositifs sont généralement des dispositifs optiques dont l'élément rotatif est constitué d'un miroir relié à un cadre fixe par l'intermédiaire de deux poutres élastiques en torsion définissant l'axe de rotation du miroir. En variante, l'élément rotatif est mobile selon deux axes de rotation. Le miroir est alors relié à un premier cadre mobile à l'aide de deux poutres de torsion, lequel est lui même relié au cadre fixe par l'intermédiaire de deux autres poutres de torsion. Qu'il soit mobile selon un ou deux axes de rotation, le miroir ainsi monté permet de dévier un faisceau lumineux entre différentes positions angulaires fixes ou de balayer un espace angulaire à l'aide d'un faisceau lumineux. De tels dispositifs équipent notamment des spectromètres optiques, des imprimantes, des appareils d'imagerie médicale, des capteurs de lumière et bien d'autres appareils comportant une commande optique.

Parmi les dispositifs susmentionnés, on s'intéresse aux dispositifs actionnés de manière électromagnétique à l'aide d'un rotor formé d'au moins une spire conductrice montée solidaire de l'élément rotatif, et d'un stator comprenant deux pôles magnétiques opposés séparés par un entrefer dans lequel prend place le rotor. Plus particulièrement, on s'intéresse ici à des dispositifs munis d'une base sur laquelle est monté un MEMS comprenant un élément rotatif mobile selon au moins un axe de rotation et au moins un premier rotor formé d'une ligne conductrice, laquelle comprend deux segments disjoints de l'élément rotatif de manière à définir deux espaces vides intérieurs et extérieurs au rotor. Deux stators, formés chacun d'un pôle intérieur, d'un pôle extérieur et d'un entrefer définissant ensemble un champ magnétique *̅B̅*̅, sont montés sur la base et chacun des segments est disposé dans l'un des entrefers perpendiculairement au champ *̅B̅*̅, de sorte que les pôles intérieurs et extérieurs prennent place dans les espaces vides respectivement intérieurs et extérieurs au rotor. De tels dispositifs sont décrits dans le document EP 2 990 375 B1. Le positionnement des segments de ligne conductrice à l'intérieur des entrefers a pour effet de confiner le champ magnétique *̅B̅*̅ au strict voisinage de ces segments de ligne conductrice utiles et à l'exclusion de toute autre portion non utile du dispositif. Ce confinement est d'un grand intérêt, puisqu'il permet d'augmenter localement le champ magnétique *̅B̅*̅ et, ainsi, la force d'actionnement du miroir rotatif, tout en limitant les pertes de puissance magnétique observées dans des configurations plus standard des stators relativement aux rotors. Pour plus de détails sur la structure de tels dispositifs et sur les avantages qu'elle procure, on se référera au document EP 2 990 375 B1, et en particulier à la figure 4 qui représente une vue en perspective d'un dispositif à actionnement électromagnétique d'un miroir mobile selon deux axes de rotation.

Le dispositif représenté en figure 4 du brevet EP 2 990 375 B1, bien que très performant, n'est pas exempt de défauts, notamment en ce qui concerne la fiabilité. On comprend bien qu'avec des dimensions de l'ordre du centimètre carré, le type de dispositif décrit dans le document EP 2 990 375 B1 requiert une grande précision, notamment en ce qui concerne le positionnement des stators relativement aux rotors. En effet, les segments de lignes conductrices prenant place à l'intérieur des entrefers, disposent de peu de jeu pour se mouvoir sous l'effet du champ magnétique. Un alignement rigoureux de ces segments par rapport aux entrefers est donc indispensable au bon fonctionnement du dispositif. Le montage du MEMS et des stators sur la base est ainsi réalisé avec le plus grand soin. Or, des tests de fiabilité prenant la forme de cycles en température sur une durée de un mois, montrent que les stators se déplacent sur la base sous l'effet du stress thermique. La raison en est la détérioration de la colle époxy utilisée pour fixer les stators sur leur base, conjuguée aux forces d'attraction et/ou de répulsion exercées mutuellement par des stators voisins. Des chocs ou des vibrations répétés conduisent au même résultat, ce qui s'explique là aussi par les contraintes qu'exercent les stators les uns sur les autres et la rupture de la colle. On note que la rupture de la colle se situe entre la base et les stators, c'est à dire au point où les contraintes s'exercent en cisaillement. La colle résiste bien mieux aux contraintes en traction simple. Les déplacements observés, bien que faibles (de l'ordre d'un dixième de millimètre), sont suffisants pour perturber le fonctionnement de tels dispositifs, dont les dimensions sont elles-mêmes très petites. On observe en particulier que les segments de la ligne conductrice se bloquent ou se rompent à l'intérieur des entrefers, en raison du changement de position des stators. L'actionnement électromagnétique est alors inopérant et le miroir mobile est bloqué dans une position fixe. Il est important de noter, pour la bonne compréhension de l'invention, que le déplacement des stators lors des tests de fiabilité est causé par la combinaison de la détérioration de la colle et des forces magnétiques exercées entre stators. Ces facteurs pris séparément ne produisent pas le déplacement d'un ou plusieurs éléments sur la base. Le MEMS, par exemple, qui est aussi collé à la base, mais n'est soumis à aucune force, reste fixe lors des tests de fiabilité.

La présente invention a pour but de remédier à cet inconvénient, en proposant un dispositif micromécanique dans lequel les stators sont montés sur la base de façon fixe les uns relativement aux autres.

Plus précisément, l'invention concerne un dispositif micromécanique à actionnement électromagnétique comprenant une base et un MEMS monté sur cette base, le MEMS comprenant un élément rotatif mobile selon un premier axe de rotation et un premier rotor formé d'une ligne conductrice, laquelle comprend deux premiers segments disjoints de l'élément rotatif de manière à définir deux espaces vides intérieurs et extérieurs au premier rotor. La base comprend encore deux premiers stators formés chacun d'un premier pôle intérieur, d'un premier pôle extérieur et d'un premier entrefer définissant ensemble un champ magnétique *̅B̅*̅, chacun des premiers segments étant disposé dans l'un des premiers entrefers perpendiculairement au champ *̅B̅*̅, de sorte que les premiers pôles intérieurs et extérieurs prennent place dans les espaces vides respectivement intérieurs et extérieurs audit premier rotor. Selon l'invention, les premiers pôles intérieurs sont montés sur la base solidairement l'un de l'autre. Dans un mode de réalisation particulièrement intéressant du dispositif selon l'invention, les premiers pôles intérieurs forment une pièce d'un seul tenant.

Grâce au fait que les pôles intérieurs des stators sont montés solidairement les des autres, et en particulier se présentent sous la forme d'une unique pièce, les forces magnétiques qui exercent une contrainte en cisaillement entre les stators et la base ne peuvent produire aucun déplacement des uns relativement aux autres. Seul le bloc complet formé de l'ensemble des pôles intérieurs aux rotors peut théoriquement se mouvoir, mais il ne subit pas de contraintes particulières qui, ajoutées à la détérioration de la colle époxy, pourraient générer un déplacement accidentel. Les caractéristiques et les avantages de la présente invention apparaîtront plus clairement à la lecture de la description qui suit, donnée uniquement à titre d'exemple, et faite en référence aux dessins annexés dans lesquels :
- La figure 1 est une vue en perspective d'un premier mode de réalisation d'un dispositif à actionnement électromagnétique selon l'invention comportant un élément rotatif selon un premier axe de rotation,
- La figure 2 représente une coupe longitudinale du dispositif illustré en figure 1,
- Les figures 3 et 4 sont des coupes longitudinales respectivement d'un deuxième et d'un troisième mode de réalisation d'un dispositif selon l'invention,
- La figure 5 est une vue en perspective d'un premier mode de réalisation d'un dispositif à actionnement électromagnétique selon l'invention comportant un élément rotatif selon un premier et un deuxième axe de rotation,
- La figure 6 est une vue en coupe du dispositif illustré en figure 5,
- Les figures 7 et 8 sont des vues en coupe respectivement d'un deuxième et d'un troisième mode de réalisation d'un dispositif selon l'invention comportant un élément rotatif selon un premier et un deuxième axe de rotation, et
- Les figures 9 et 10 sont des vues respectivement en perspective et en coupe d'une variante du troisième mode de réalisation illustré en figure 8.

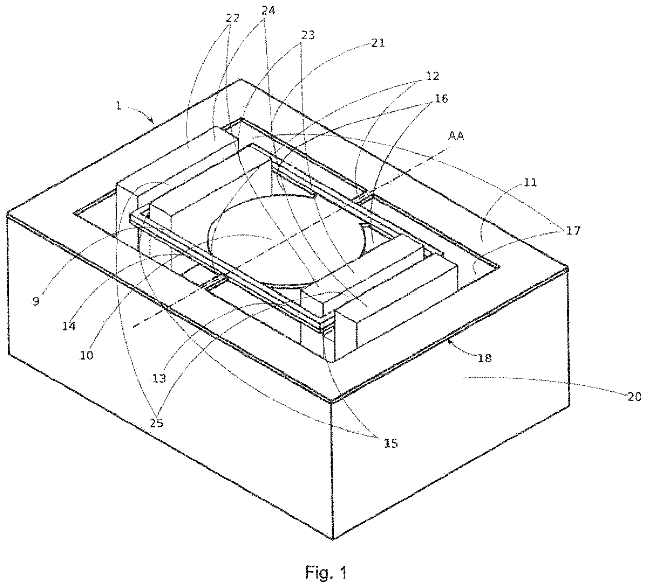

Le dispositif micromécanique à actionnement électromagnétique local représenté en figure 1, et référencé dans son ensemble 1, comprend classiquement un élément rotatif 10, monté mobile en rotation selon un premier axe de rotation AA sur un cadre fixe 11, par l'intermédiaire de deux poutres de torsion 12. L'élément rotatif 10 est un élément optiquement actif, tel qu'un miroir, un réseau de diffraction, une lentille ou tout autre composant destiné à interagir avec un faisceau lumineux. Il est monté solidaire en rotation d'un rotor 13 formé d'un cadre mobile 14 surmonté d'une ligne conductrice 9. Le rotor 13 est de géométrie sensiblement rectangulaire ou carrée, et comprend deux segments 15 disjoints de l'élément rotatif 10, parallèles à l'axe de rotation AA et symétriques par rapport audit axe de rotation AA. Chacun des segments 15 est séparé, d'une part, de l'élément rotatif 10 par un espace vide 16 intérieur audit rotor 13, et d'autre part, du cadre fixe 11 par un espace vide 17 extérieur audit rotor 13. La fonction des espaces vides intérieur 16 et extérieur 17 sera décrite ultérieurement. L'ensemble composé de l'élément rotatif 10, du cadre fixe 11, des poutres de torsion 12 et du rotor 13 est fabriqué d'une seule pièce 18 à partir d'une plaquette de SIO (de l'anglais Silicon On Oxide), par des opérations de photolithographie, et est connu sous l'appellation de MEMS (de l'anglais Micro Electro Mechanical System). La ligne conductrice 9 est classiquement une piste métallique obtenue par un procédé de dépôt par pulvérisation. La dimension de l'ensemble est de l'ordre du centimètre carré.

Le cadre fixe 11 est monté collé sur une base métallique 20 formée d'un parallélépipède rectangle comportant un dégagement 21 de dimensions choisies pour recevoir l'élément rotatif 10, le rotor 13 et l'ensemble des pièces du dispositif 1. Deux stators 22 comportant chacun deux pôles 23, 24 séparés l'un de l'autre par un entrefer 25, sont montés sur la base métallique 20, dans le dégagement 21, de manière à recevoir dans les entrefers 25 les segments 15 du rotor 13. Les pôles 23 situés dans les espaces vides 16 intérieurs au rotor 13 sont dits pôles intérieurs 23, tandis que les pôles 24 prenant place dans les espaces vides 17 extérieurs au rotor 13 sont dits pôles extérieurs 24. Dans cette configuration, l'élément rotatif 10 est actionné en rotation par les stators 22 qui coopèrent avec les segments 15 du rotor 13, sans perte de puissance magnétique et avec une efficacité supérieure à celle des dispositifs classiques.

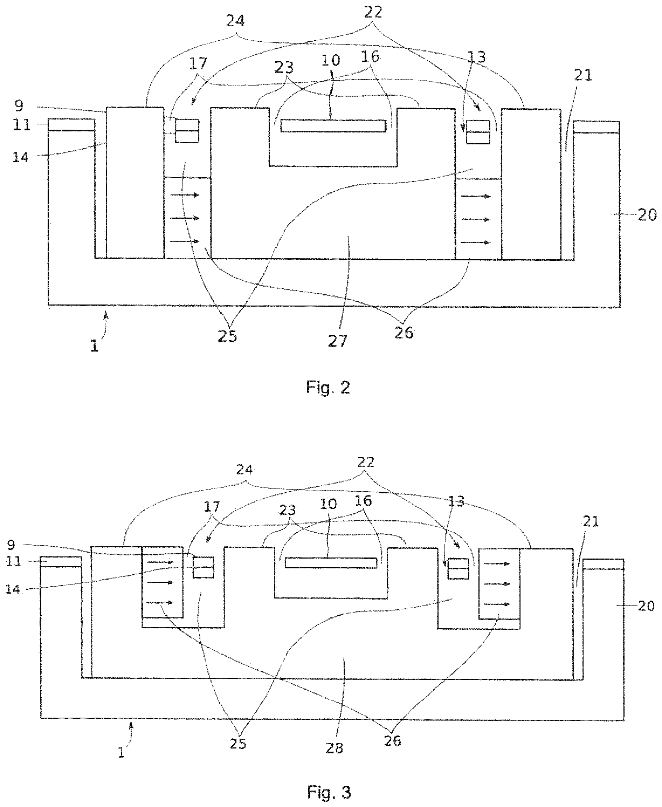

On se réfère maintenant à la figure 2 représentant une vue en coupe longitudinale du dispositif décrit en liaison avec la figure 1. La base métallique 20 forme un parallélépipède creux sur lequel est collé le cadre fixe 11, solidaire du rotor 13 et de l'élément rotatif 10. Les stators 22 sont collés sur la base 20, dans le dégagement 21, de manière à recevoir les segments 15 du rotor 13 dans leurs entrefers 25. Un aimant 26, générant un champ magnétique *̅B̅*̅, est disposé entre les pôles intérieurs 23 et extérieurs 24, définissant ainsi l'entrefer 25 de chaque stator 22. La base 20 est constituée d'un métal amagnétique de façon à ne pas dévier le champ magnétique *̅B̅*̅ circulant entre les pôles intérieurs 23 et extérieurs 24.

Selon l'invention, les pôles intérieurs 23 sont montés solidaires l'un de l'autre sur la base 20. Plus précisément, les pôles 23 sont formés d'une pièce 27 en U, d'un seul tenant, montée sur la base 20 de manière à venir s'insérer dans les espaces vides intérieurs 16. De la sorte, les pôles intérieurs 23 n'exercent pas de contraintes mutuelles susceptibles de produire un déplacement de l'un ou de l'autre sous l'effet du vieillissement de la colle et des forces en présence. Les pôles extérieurs 24 sont eux-mêmes solidaires des pôles intérieurs 23 par l'intermédiaire des aimants 26, lesquels sont collés par une face aux pôles intérieurs 23 et par une autre face aux pôles extérieurs 24. Ainsi, les deux stators 22 forment un bloc composé de pièces assemblées par collage, et les contraintes subies par le bloc sont internes mais non externes. Le bloc formé des deux stators 22 ne se déplace donc pas dans son ensemble, mais subit des contraintes magnétiques internes de trois types : De pôle intérieur 23 vers pôle intérieur 23, de pôle intérieur 23 vers pôle extérieur 24 et de pôle extérieur 24 vers pôle extérieur 24. Les premières ne produisent aucun déplacement du fait que les pôles intérieurs 23 ne forment qu'une pièce 27. Les deuxièmes et troisièmes type de contraintes, d'attraction et de répulsion, peuvent induire des forces de cisaillement, mais uniquement dans le cas de la répulsion entre un pôle intérieur 23 et un pôle extérieur 24 opposés, ou entre les deux pôles extérieurs 24. Dans ces deux cas, le collage des pôles extérieurs 24 à la pièce 27 en U, par l'intermédiaire des aimants 26, assure la stabilité des pôles extérieurs 24. Ainsi monté, le dispositif micromécanique 1 subit avec succès les tests de stress thermique, sans déplacement des stators 22 et donc sans blocage du rotor 13.

La figure 3 représente une vue en coupe longitudinale d'un deuxième mode de réalisation d'un dispositif à actionnement électromagnétique local selon l'invention. Sur cette figure 3, on retrouve un MEMS 18 formé d'un élément rotatif 10 monté sur un cadre fixe 11 par l'intermédiaire de poutres de torsion 12, le cadre fixe 11 étant monté collé sur une base métallique 20. Les stators 22 sont disposés dans le dégagement 21 de manière à ce que les segments 15 soient placés dans les entrefers 25. Ce deuxième mode de réalisation se distingue du premier en ce que les pôles extérieurs 24 et intérieurs 23 des deux stators 22 sont formés d'une pièce 28 en triple U d'un seul tenant, montée sur la base métallique 20 de manière à venir s'insérer dans les espaces vides intérieurs 16 et extérieurs 17. Les aimants 26 sont collés, à l'intérieur des entrefers 25, sur la face intérieure des pôles extérieurs 24, de manière à générer un champ magnétique *̅B̅*̅. En variante, les aimants 26 sont collés sur la face extérieure des pôles intérieurs 23. La base métallique 20 est en métal amagnétique de manière à ne pas perturber le champ magnétique *̅B̅*̅ à l'intérieur des entrefers 25. Dans cette configuration, les deux stators 22 forment un bloc d'un seul tenant comportant deux pièces collées, à savoir les aimants 26. Comme précédemment, les contraintes subies par le bloc sont internes mais non externes, et elles n'agissent que sur les aimants 26. Ces contraintes sont de type attraction ou répulsion, mais non de type cisaillement, et dans cette configuration, la colle époxy présente une bonne résistance. Le présent mode de réalisation présente donc un avantage sur le mode de réalisation précédent, à savoir que les forces de cisaillement entre les pôles 23, 24 et la base 20 sont totalement absentes, alors qu'il y a des forces de cisaillement résiduelles dans le mode de réalisation précédent. La résistance au test de stress thermique est encore augmentée, et on note encore que le montage d'un tel dispositif est largement facilité par rapport à un dispositif classique, puisqu'il n'y a qu'une seule pièce à aligner par rapport au MEMS 18, à savoir la pièce 28.

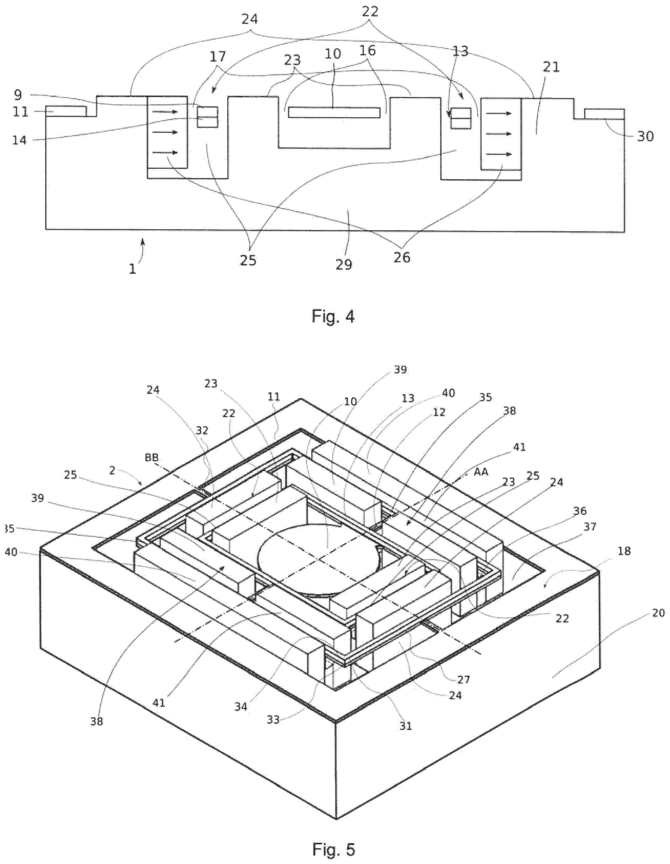

On se réfère maintenant à la figure 4 qui est une vue en coupe longitudinale d'un troisième mode de réalisation d'un dispositif à actionnement électromagnétique local selon l'invention. Ce mode de réalisation se distingue du précédent en ce que la base 20 et la pièce 28 en triple U sont confondues en une pièce 29 d'un seul tenant. Une surface plate 30, courant sur le pourtour de la pièce 29, est destinée à recevoir le cadre fixe 11. La pièce 29 est en matériau magnétique de manière à induire un champ magnétique *̅B̅*̅ dans les entrefers 25. Ce mode de réalisation présente tous les avantages du précédent mode de réalisation, à savoir l'absence de contraintes de cisaillement entre les stators 22 et la base, plus quelques autres. Tout d'abord, la structure est simplifiée et l'opération de collage de la pièce 28 sur la base 20 est supprimée. Du même coup, tout problème potentiel de collage ou de déplacement de la pièce 28 par rapport à la base 20 disparaît simultanément. L'alignement du MEMS 18 avec les stators 22 se fait en une seule opération, celle du collage du cadre fixe 11 sur la surface 30. Pour faciliter l'alignement du MEMS 18 par rapport à la pièce 29, des ergots 8 disposés aux quatre coins de la base 20 viennent se loger dans des encoches 7 pratiquées aux quatre coins du MEMS 18. Le nombre d'opérations de montage et les coûts de fabrication sont donc réduits, alors que la fiabilité du dispositif 1 est encore augmentée.

La figure 5 est une vue en perspective d'un dispositif à actionnement électromagnétique 2 selon l'invention, comportant un élément rotatif selon un premier et un deuxième axe de rotation, respectivement AA et BB. Ce type de dispositif est décrit de façon détaillée dans le document EP 2 990 375 B1, et pour plus d'explications sur sa structure et ses avantages, on se référera à ce brevet. On se contente dans le paragraphe suivant de présenter les éléments utiles pour la compréhension de l'invention. La structure du dispositif 2 est tout à fait similaire à celle du dispositif 1, à cela près qu'elle comporte un deuxième axe de rotation. L'élément rotatif 10 est monté solidaire en rotation du premier rotor 13 sur un deuxième rotor 31 par l'intermédiaire des poutres de torsion 12 définissant l'axe AA, le deuxième rotor 31 étant lui-même monté libre en rotation sur le cadre fixe 11 à l'aide de poutres de torsion 32 définissant l'axe BB. Le deuxième rotor 31 est formé d'un cadre mobile 33 surmonté d'une ligne conductrice 34, et comprend deux deuxièmes segments 35 séparés du premier rotor 13 par un espace vide 36 intérieur au deuxième rotor 31 d'une part, et séparés du cadre fixe 11 par un espace vide 37 extérieur audit deuxième rotor 31 d'autre part. Le dispositif à actionnement électromagnétique 2 comprend encore deux deuxièmes stators 38 formés chacun d'un deuxième pôle intérieur 39, d'un deuxième pôle extérieur 40 et d'un deuxième entrefer 41 définissant ensemble un champ magnétique *̅B̅*̅. Chacun des deuxièmes segments 35 est disposé dans l'un des deuxièmes entrefers 41 perpendiculairement au champ *̅B̅*̅, les deuxièmes pôles intérieurs 39 et extérieurs 40 prenant place dans les espaces vides respectivement intérieurs 36 et extérieurs 37 au deuxième rotor 31. Sur le principe, le fonctionnement de ce dispositif est identique à celui du dispositif décrit en regard de la figure 1, à cela près que l'élément rotatif 10, commandé par le premier et le deuxième rotors 13, 31, peut être actionné en rotation selon les deux axes AA et BB.

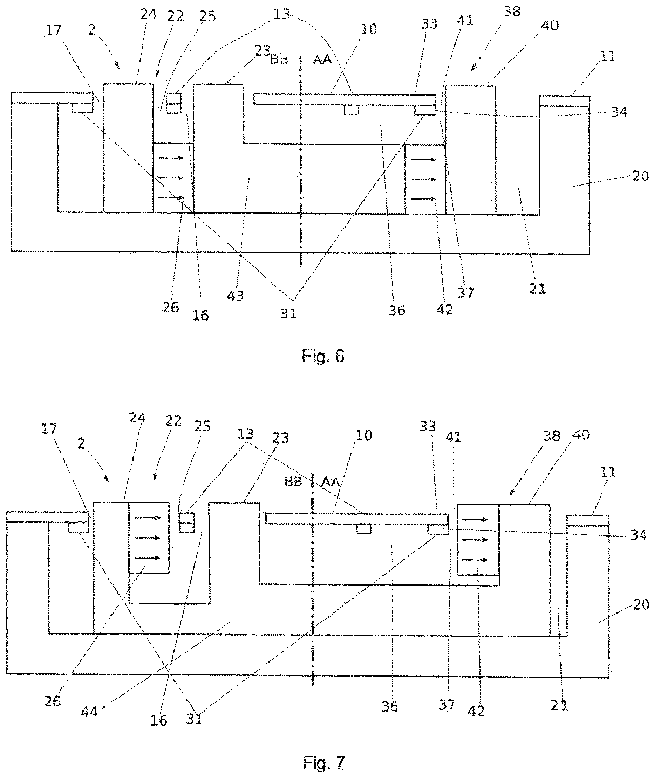

On se réfère maintenant à la figure 6 qui présente une coupe AB du dispositif 2 décrit en regard de la figure 5. Cette vue en coupe est très similaire à celle décrite en regard de la figure 2. Un premier et un deuxième stators 22, 38 sont montés collés sur la base 20. Ils reçoivent dans leurs entrefers respectifs 25, 41 les premier et deuxième segments 15, 35. Un aimant 42 est interposé entre les deuxièmes pôles intérieur 39 et extérieur 40 du deuxième stator 38. Selon l'invention, les premier et deuxième pôles intérieurs 23, 39 sont montés solidaires sur la base 20. Plus précisément, les pôles intérieurs 23, 39 sont constitués d'une unique pièce 43, formant une croix dans le plan de la base 20, surmontée de quatre barreaux venant s'insérer dans les espaces vides intérieurs 16, 36. Les pôles extérieurs 40 sont eux-mêmes solidaires des pôles intérieurs 39 par l'intermédiaire des aimants 42, lesquels sont collés par une face aux pôles intérieurs 39 et par une autre face aux pôles extérieurs 40. Ce mode de réalisation est similaire à celui illustré en figure 2, et présente les mêmes avantages que ce dernier.

De la même manière, le mode de réalisation illustré en figure 7 est semblable, sur le principe, au mode de réalisation décrit en regard de la figure 3. Ce mode de réalisation se distingue du précédent en ce que les pôles intérieurs et extérieurs 39, 40 sont formés d'une pièce d'un seul tenant 44, laquelle est montée collée sur la base 20. Là encore, les avantages liés à ce mode de réalisation sont déjà décrits en regard de la figure 3.

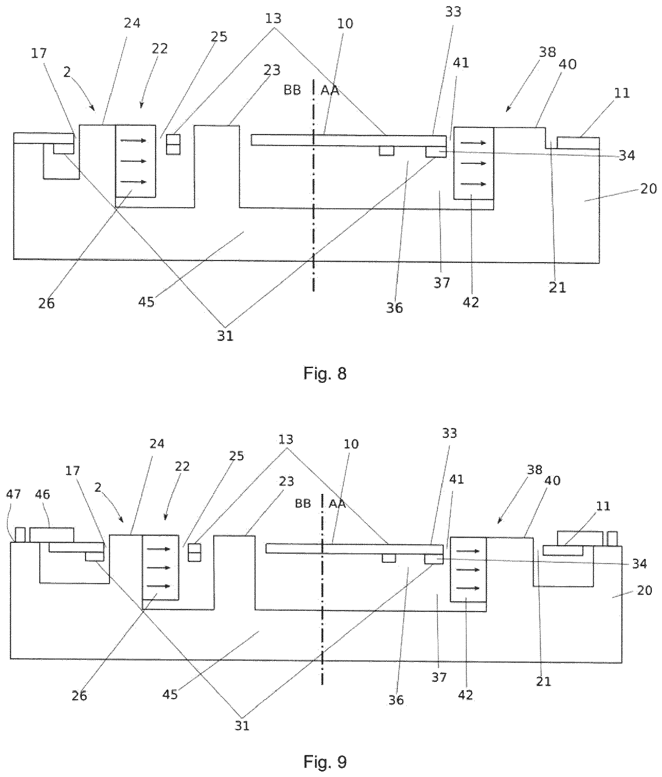

On se réfère maintenant à la figure 8, qui représente un troisième mode de réalisation du dispositif 2 selon l'invention. Sur le principe, ce mode de réalisation est semblable au mode de réalisation illustré en figure 4. Il se distingue du précédent en ce que la pièce 44 forme, avec la base 20, une pièce d'un seul tenant 45, sur laquelle est monté le MEMS 18. Dans ce mode de réalisation très avantageux, l'ensemble des premiers et deuxièmes stators 22, 38 sont confondus avec la base 20 et les seules pièces collées sont les aimants 26, 42. Les avantages de ce mode de réalisation sont explicités en regard de la figure 4.

Finalement, on se réfère aux figure 9 qui illustrent une variante du mode de réalisation précédent. Dans cette variante, le MEMS 18 n'est pas directement fixé à la pièce 45, mais indirectement, par l'intermédiaire d'une plaque 46 elle-même soudée à la pièce 45 en quatre points 47. La plaque 46 est réalisée dans un métal ayant un coefficient de dilatation thermique proche du silicium, par exemple le kovar ou l'acier inoxydable. Elle comporte des découpes sensiblement rectangulaires 47 au voisinage des points de soudure 47, destinées à absorber par élasticité la différence de dilatation thermique entre la plaque 46 et la pièce 45. Le MEMS 18 est collé sous ou sur la plaque 46. Dans cette configuration, les quelques tensions résiduelles dues aux variations de température sont absorbées par la plaque intermédiaire 46, et le MEMS 18 est exempt de ces tensions. La résistance du dispositif 2 au stress thermique s'en trouve d'autant améliorée.

Ainsi a été décrit un dispositif à actionnement électromagnétique local. Bien entendu, la présente invention ne se limite pas aux modes de réalisation décrits ci-dessus, mais s'étend à toutes les variantes à la portée de l'homme de métier, s'inscrivant dans le cadre des revendications ci-après.

## Revendications

1. Dispositif micromécanique (1, 2) à actionnement électromagnétique comprenant :
- Une base (20)
- Une plaque (46)
- Un MEMS (18), monté indirectement par l'intermédiaire de ladite plaque (46) sur ladite base (20), comprenant un élément rotatif (10) mobile selon un premier axe de rotation (AA) et un premier rotor (13) formé d'au moins une ligne conductrice (9), et comprenant deux premiers segments (15) disjoints dudit élément rotatif (10) de manière à définir deux espaces vides intérieurs (16) et extérieurs (17) audit premier rotor (13),
- Deux premiers stators (22) formés chacun d'un premier pôle intérieur (23), d'un premier pôle extérieur (24) et d'un premier entrefer (25) définissant ensemble un champ magnétique *̅B̅*̅, chacun desdits premiers segments (15) étant disposé dans l'un des premiers entrefers (25) perpendiculairement au champ *̅B̅*̅, de sorte que lesdits premiers pôles intérieurs (23) et extérieurs (24) prennent place dans lesdits espaces vides respectivement intérieurs (16) et extérieurs (17) audit premier rotor (13),
Ledit dispositif étant **caractérisé en ce que** lesdits premiers pôles intérieurs (23) sont montés solidaires l'un de l'autre sur ladite base (20) et que le MEMS (18) soit monté indirectement par l'intermédiaire de ladite plaque (46) sur ladite base (20).

2. Dispositif micromécanique selon la revendication 1, **caractérisé en ce que** ledit MEMS (18) est fixé à ladite base (20) à l'aide d'une plaque métallique intermédiaire (46) de coefficient de dilatation proche de celui du silicium.

3. Dispositif micromécanique selon l'une des revendications 1 et 2, **caractérisé en ce que** la plaque intermédiaire (46) comporte des découpes sensiblement rectangulaires au voisinage des points de soudure (47) qui l'attachent à la base (20).

4. Dispositif micromécanique (2) selon l'une des revendications 1 à 3, **caractérisé en ce que** :
- Ledit élément rotatif (10) est mobile selon un deuxième axe de rotation (BB),
- Ledit MEMS (18) comporte un deuxième rotor (31) formé d'une ligne conductrice (34), et comprenant deux deuxièmes segments (35) disjoints dudit premier rotor (13) de manière à définir deux espaces vides intérieurs (36) et deux espaces vides extérieurs (37) audit deuxième rotor (31),
- Ledit dispositif à actionnement électromagnétique comprend en outre deux deuxièmes stators (38) formés chacun d'un deuxième pôle intérieur (39), d'un deuxième pôle extérieur (40) et d'un deuxième entrefer (41) définissant ensemble un champ magnétique *̅B̅*̅ chacun desdits deuxièmes segments (35) étant disposé dans l'un des deuxièmes entrefers (41) perpendiculairement au champ *̅B̅*̅, de sorte que lesdits deuxièmes pôles intérieurs (39) et extérieurs (40) prennent place dans lesdits espaces vides respectivement intérieurs (36) et extérieurs (37) audit deuxième rotor (31), et **en ce que**
- Lesdits premiers et deuxièmes pôles intérieurs (23, 39) sont montés sur ladite base (20) solidairement les uns des autres.

5. Dispositif micromécanique (2) selon la revendication 4, **caractérisé en ce que** lesdits premiers et deuxièmes pôles intérieurs (23, 39) forment une pièce (43) d'un seul tenant.

6. Dispositif micromécanique (2) selon l'une des revendications 4 et 5, **caractérisé en ce que** lesdits premiers et deuxièmes stators (13, 31) comportent un aimant (26, 42) accolé audits pôles intérieurs (23, 39), lesdits pôles extérieurs (24, 40) étant eux-mêmes accolés audit aimant (26, 42) de manière à définir lesdits premiers et deuxièmes entrefers (25, 41).

7. Dispositif micromécanique (2) selon l'une des revendications 4 et 5, **caractérisé en ce que** lesdits premiers et deuxièmes stators (22, 38) comportent un aimant accolé audits pôles extérieurs (24, 40), et **en ce que** lesdits pôles extérieurs (24, 40) sont solidaires desdits pôles intérieurs (23, 39).

8. Dispositif micromécanique selon la revendication 7, **caractérisé en ce que** lesdits pôles intérieurs et extérieurs (23, 24, 39, 40) sont confondus avec ladite base (20), formant une pièce (45) d'un seul tenant en matériau ferromagnétique.
